# EUROPÄISCHE PATENTSCHRIFT

(11) **EP 3 380 909 B1**
(45) Veröffentlichungstag und Bekanntmachung des Hinweises auf die Patenterteilung: **05.08.2020**
(21) Anmeldenummer: 16798483.0
(22) Anmeldetag: 18.11.2016
(51) Int. Cl.: G06F 3/01, B60K 35/00, B06B 1/04, G06F 3/041, H01H 13/30, H01H 36/00, H01H 51/34, H03K 17/96

(54) **BEDIENVORRICHTUNG FÜR EIN KRAFTFAHRZEUG MIT ANTRIEBSEINRICHTUNG ZUM AUSGEBEN EINER HAPTISCHEN RÜCKMELDUNG SOWIE KRAFTFAHRZEUG**
OPERATING DEVICE FOR MOTOR VEHICLE WITH DRIVE MECHANISM FOR OUTPUT OF HAPTIC FEEDBACK AS WELL AS MOTOR VEHICLE
APPAREIL POUR VÉHICULE AUTOMOBILE AVEC DISPOSITIF D'ACTIONNEMENT POUR ÉMETTRE UN FEEDBACK HAPTIQUE AINSI QUE VÉHICULE AUTOMOBILE

(30) Priorität: 27.11.2015 DE 102015120605
(43) Veröffentlichungstag der Anmeldung: 03.10.2018
(73) Patentinhaber: Valeo Schalter und Sensoren GmbH, 74321 Bietigheim-Bissingen (DE)
(72) Erfinder: HENTSCHEL, Joachim, 96476 Bad Rodach (DE); SCHMITT, Martin, 96476 Bad Rodach (DE)
(74) Vertreter: Pothmann, Karsten
(86) Internationale Anmeldenummer: PCT/EP2016/078171
(87) Internationale Veröffentlichungsnummer: WO 2017/089240

(56) Entgegenhaltungen:
- WO-A2-2009/095852
- US-A1- 2003 128 191
- US-B1- 6 982 696

## Beschreibung

Die vorliegenden Erfindung betrifft eine Bedienvorrichtung für ein Kraftfahrzeug mit einem Bedienelement, mit einer Erfassungseinrichtung zum Erfassen einer an dem Bedienelement durchgeführten Bedieneingabe und einer Antriebseinrichtung, mittels welcher das Bedienelement in Abhängigkeit von der mit der Erfassungseinrichtung erfassten Bedieneingabe zum Ausgeben einer haptischen Rückmeldung bewegbar ist, wobei die Antriebseinrichtung einen Elektromagneten und ein Bewegungselement, welches durch die Ansteuerung des Elektromagneten bewegbar ist, aufweist. Darüber hinaus betrifft die vorliegende Erfindung ein Kraftfahrzeug mit einer solchen Bedienvorrichtung.

Das Interesse richtet sich vorliegend insbesondere auf Bedienvorrichtungen für Kraftfahrzeuge. Derartige Bedienvorrichtungen sind in unterschiedlichen Ausführungsformen aus dem Stand der Technik bekannt. Solche Bedienvorrichtungen umfassen üblicherweise ein Bedienelement, welches zum Durchführen einer Bedienhandlung betätigbar ist. Die Betätigung kann dabei beispielsweise mit zumindest einem Finger oder einem entsprechenden Eingabegerät erfolgen. Die Bedieneingabe kann mit einer entsprechenden Erfassungseinrichtung erfasst werden. Infolge der erfassten Bedienhandlung kann ein entsprechendes Steuersignal ausgegeben werden, mit dem eine der Bedienvorrichtung zugeordnete Funktionseinrichtung des Kraftfahrzeugs angesteuert werden kann. Eine solche Funktionseinrichtung kann beispielsweise ein Informations- und Unterhaltungssystem, ein Navigationssystem, eine Klimaanlage oder dergleichen sein.

Darüber hinaus sind aus dem Stand der Technik Bedienvorrichtungen bekannt, die eine Antriebseinrichtung aufweisen. Wenn mit der Erfassungseinrichtung eine Berührung beziehungsweise Betätigung des Bedienelements erkannt wird, kann mit dieser Antriebseinrichtung eine haptische Rückmeldung ausgegeben werden. Auf diese Weise kann die Bedienhandlung durch die haptische Rückmeldung quasi bestätigt werden. Zum Ausgeben der haptischen Rückmeldung kann das Bedienelement mittels der Antriebseinrichtung in mechanische Schwingungen versetzt werden. Diese Schwingungen können dann an den zumindest einen Finger des Bedieners übertragen werden.

In diesem Zusammenhang beschreibt die WO 2013/034507 A2 eine Bedieneinrichtung für ein elektrisches Gerät, mit einem Betätigungselement mit haptischer Rückmeldung, das eine berührungssensitive Bedienfläche aufweist, wobei das Betätigungselement von einer Bedienperson mittels eines Eingabeorgans betätigbar ist und ein Betätigungssignal auslösbar ist und wobei das Betätigungselement um eine Schwenkachse zwischen einer Ruhelage und einer Schaltlage schwenkbar gelagert ist. Dabei ist es vorgesehen, dass durch das Betätigungssignal ein elektromagnetischer Aktuator zur Erzeugung eines Magnetfelds ansteuerbar ist, durch das ein rotatorisch gelagertes, magnetisch beeinflussbares Element aus einer Ausgangslage in eine Schwenklage bewegbar ist, wobei durch die Bewegung des magnetisch beeinflussbaren Elements direkt oder indirekt ein das Betätigungselement aus der Ruhelage in die Schaltlage bewegbares Moment auf das Betätigungselement einwirkbar ist.

Darüber hinaus beschreibt die DE 10 2009 007 243 B4 eine haptische Bedieneinrichtung für Kraftfahrzeuge. Die Bedieneinrichtung umfasst mindestens einen berührungsempfindlichen Tastbereich, wobei bei einer Berührung des Tastbereichs ein Schaltsignal auslösbar ist und das Tastfeld durch einen mit dem Tastfeld gekoppelten Ankers eines Magnetbewegungsantriebs in der Ebene des Tastfelds in einem bestimmten Rhythmus bewegbar antreibbar ist. Dabei ist es vorgesehen, dass der Magnetbewegungsantrieb einen Klappanker-Magneten mit einem von einer Spule umschlossenen Eisenkern und eine um eine Schwenkachse schwenkbar gelagerte Ankerplatte aufweist, die mit dem Tastfeld gekoppelt ist.

Darüber hinaus beschreibt die US 2015/0002279 A1 einen Magneten, mit dem eine haptische Rückmeldung ausgegeben werden kann. Der Magnet umfasst ein feststehendes Element, das eine Spule umfasst, und ein bewegliches Element, welches mit einem Anzeigeelement verbunden ist. Wenn die Spule bestromt wird, wird das bewegliche Element in Richtung des feststehenden Elements bewegt, so dass das bewegliche Element mit dem feststehenden Element in Verbindung steht und somit ein magnetischer Kreis geschlossen ist.

Die US 6 982 696 B1 offenbart eine Bedienvorrichtung mit einem Bedienelement sowie einem Aktuator zur Erzeugung einer haptischen Rückmeldung bei Betätigung des Bedienelements. Der Aktuator weist einen Elektromagneten sowie ein davon mitbewegtes Bewegungselement auf, um die haptische Rückmeldung zu erzeugen.

Die WO 2009/095852 A2 offenbart einen Aktuator für eine Mensch-Maschine-Schnittstelle, um bei Betätigung eine haptische Rückmeldung für den Anwender zu erzeugen. Der Aktuator weist ein Substrat, eine bewegbare Masse, eine Feder sowie eine Antriebseinheit auf. Das Federelement ist mit der bewegbaren Masse gekoppelt, welche von der Antriebseinheit angetrieben wird.

Es ist Aufgabe der vorliegenden Erfindung, eine Lösung aufzuzeigen, wie eine Bedienvorrichtung mit einer Antriebseinrichtung, die einen Elektromagneten aufweist, effizienter betrieben werden kann.

Diese Aufgabe wird erfindungsgemäß durch eine Bedienvorrichtung sowie durch ein Kraftfahrzeug mit den Merkmalen gemäß den jeweiligen unabhängigen Ansprüchen gelöst. Vorteilhafte Weiterbildungen der vorliegenden Erfindung sind Gegenstand der abhängigen Ansprüche, der Beschreibung und der Figuren.

Eine erfindungsgemäße Bedienvorrichtung für ein Kraftfahrzeug umfasst ein Bedienelement. Darüber hinaus umfasst die Bedienvorrichtung eine Erfassungseinrichtung zum Erfassen einer an dem Bedienelement durchgeführten Bedieneingabe. Ferner umfasst die Bedienvorrichtung eine Antriebseinrichtung, mittels welcher das Bedienelement in Abhängigkeit von der mit der Erfassungseinrichtung erfassten Bedieneingabe zum Ausgeben einer haptischen Rückmeldung bewegbar ist. Dabei weist die Antriebseinrichtung einen Elektromagneten und ein Bewegungselement, welches durch eine Ansteuerung des Elektromagneten bewegbar ist, auf. Dabei sind der Elektromagnet und das Bewegungselement derart zueinander angeordnet, dass beim Bewegen des Bewegungselements ein vorbestimmter Abstand zwischen dem Elektromagneten und dem Bewegungselement bestehen bleibt.

Die Bedienvorrichtung kann in einem Kraftfahrzeug eingesetzt werden. Die Bedienvorrichtung kann in einem Innenraum des Kraftfahrzeugs, beispielsweise in der Mittelkonsole oder dem Armaturenbrett, angeordnet sein. Die Bedienvorrichtung umfasst das Bedienelement, welches beispielsweise von dem Fahrer des Kraftfahrzeugs oder einem weiteren Insassen des Kraftfahrzeugs bedient werden kann. Zum Durchführen der Bedienhandlung, bei der das Bedienelement bedient wird, kann der Fahrzeuginsasse beispielsweise mit zumindest einem Finger oder einem entsprechenden Eingabegerät auf das Bedienelement drücken oder dieses berühren. Mit Hilfe der Erfassungseinrichtung der Bedienvorrichtung kann diese Berührung beziehungsweise die Bedienhandlung erfasst werden. Die Erfassungseinrichtung kann beispielsweise ein berührungsempfindliches Sensorelement aufweisen, mit dem die Berührung der Bedienfläche erkannt werden kann. Mit Hilfe der Erfassungseinrichtung kann zudem die Position, an welcher das Bedienelement berührt wird, erfasst werden. In Abhängigkeit von der mit der Erfassungseinrichtung erfassten Bedienhandlung kann dann ein entsprechendes Steuersignal ausgegeben werden und an die Antriebseinrichtung übertragen werden.

Mit Hilfe der Antriebseinrichtung kann das Bedienelement bewegt werden. Insbesondere kann das Bedienelement mit Hilfe der Antriebseinrichtung in mechanische Schwingungen beziehungsweise in Vibrationen versetzt werden. Auf diese Weise kann dem Bediener beziehungsweise dem Fahrzeuginsassen, der aktuell das Bedienelement berührt, eine haptische Rückmeldung ausgegeben werden. Dabei ist es vorgesehen, dass die Antriebseinrichtung einen Elektromagneten und ein Bewegungselement umfasst. Durch die Ansteuerung des Elektromagneten kann das Bewegungselement bewegt werden. Zur Ansteuerung des Elektromagneten kann der Elektromagnet beziehungsweise eine Spule des Elektromagneten mit elektrischem Strom beaufschlagt werden. Von dem Elektromagneten wird dann ein Magnetfeld erzeugt, durch welches das Bewegungselement bewegt wird. Durch die Bewegung des Bewegungselements wird dann das Bedienelement bewegt beziehungsweise zu Schwingungen angeregt.

Das Bewegungselement kann zumindest teilweise aus einem magnetisierbaren Material gebildet sein. Beispielsweise kann das Bewegungselement zumindest teilweise aus einem ferromagnetischen Material, beispielsweise einem Metall, gebildet sein. In diesem Fall kann der Elektromagnet derart angesteuert werden, dass er ein Magnetfeld bereitstellt und das Bewegungselement von dem Elektromagneten angezogen wird. Das Bewegungselement wird also in Richtung des Elektromagneten bewegt. Alternativ dazu kann das Bewegungselement zumindest teilweise aus einem magnetischen Material gebildet sein. Beispielsweise kann das Bewegungselement einen Permanentmagneten umfassen. In diesem Fall kann der Elektromagnet derart angesteuert werden, dass das Bewegungselement mit dem magnetischen Material von dem Elektromagneten abgestoßen wird. Alternativ dazu kann es auch vorgesehen sein, dass das Bewegungselement einen weiteren Elektromagneten aufweist. Der Elektromagnet und der weitere Elektromagnet des Bewegungselements können derart bestromt werden, dass sie sich entweder gegenseitig anziehen oder gegenseitig abstoßen.

Erfindungsgemäß ist es nun vorgesehen, dass der Elektromagnet und das Bewegungselement derart zueinander angeordnet sind, dass beim Bewegen des Bewegungselements ein vorbestimmter Abstand zwischen dem Elektromagneten und dem Bewegungselement bestehen bleibt. Mit anderen Worten ist die Antriebseinrichtung derart ausgebildet, dass der Elektromagnet und das Bewegungselement immer einen Mindestabstand zueinander aufweisen. Dies gilt für den Fall, in dem sich das Bewegungselement in einer Ruhestellung befindet. Zudem gilt dies für den Fall, bei dem das Bewegungselement relativ zu dem Elektromagneten bewegt wird. Es ist also insbesondere nicht vorgesehen, dass infolge der Ansteuerung des Elektromagneten ein magnetischer Kreis zwischen dem Bewegungselement und dem Elektromagneten geschlossen wird und der Elektromagnet und das Bewegungselement einen direkten Kontakt aufweisen. Dies ermöglicht es insbesondere, dass die Anordnung des Elektromagneten zu dem Bewegungselement innerhalb vorbestimmter Grenzen beliebig erfolgen kann. Somit kann beispielsweise der zur Verfügung stehende Bauraum ideal ausgenutzt werden. Ferner können in dem Zwischenraum zwischen dem Bewegungselement und dem Elektromagneten, in dem der Abstand bestehen bleibt, zusätzliche Elemente angeordnet werden, mittels welcher die haptische Rückmeldung beeinflusst werden kann. Damit kann eine flexible Anordnung des Elektromagneten und des Bewegungselements zueinander ermöglicht werden.

Erfindungsgemäß umfasst die Antriebseinrichtung ein elastisches Element, welches durch die Bewegung des Bewegungselements von einem stabilen Zustand in einem metastabilen Zustand verformbar ist. Mit anderen Worten kann das Bewegungselement nach Art eines Knackfrosches ausgebildet sein. Das elastische Element kann beispielsweise aus einem Federstahl gebildet sein, der so geformt ist, dass er durch die Relativbewegung des Bewegungselements zu dem Elektromagneten elastisch verformt wird. In diesem Fall ist das Bewegungselement bevorzugt zumindest teilweise aus dem magnetisierbaren Material gebildet und das Bewegungselement wird bei der Bewegung durch den Elektromagneten angezogen. Das elastische Element, das zwischen dem Elektromagneten und dem Bewegungselement angeordnet ist, wird durch die Bewegung des Bewegungselements elastisch verformt und somit von dem stabilen Zustand in den metastabilen Zustand überführt. Dabei ist es insbesondere vorgesehen, dass das Bewegungselement mit dem Bedienelement verbunden ist. Durch die Ausgestaltung des elastischen Elements kann die haptische Rückmeldung entsprechend ausgestaltet werden. Dies ergibt sich durch die Verformung des elastischen Elements. Somit kann durch das elastische Element die haptische Rückmeldung an die Ausgestaltung des Bedienelements angepasst werden.

Weiterhin ist es vorteilhaft, wenn zwischen dem Elektromagneten und dem Bewegungselement zumindest ein Dämpfungselement angeordnet ist. Dies eignet sich insbesondere für die Ausgestaltung, bei der das Bewegungselement von dem Elektromagneten angezogen ist. Das Dämpfungselement kann beispielsweise aus einem Gummi oder aus Silikon gebildet sein. Die Dicke des Dämpfungselements kann dabei so gewählt sein, dass diese größer ist als der Abstand, der mindestens bei der Bewegung zwischen dem Bewegungselement und dem Elektromagneten bestehen bleibt. Somit wird die Bewegung des Bewegungselements in Richtung des Elektromagneten durch das Dämpfungselement begrenzt beziehungsweise gedämpft. Damit können beispielsweise störende Geräusche verhindert werden, die entstehen würden, wenn das Bewegungselement auf den Elektromagneten auftrifft.

In einer weiteren Ausgestaltung weist die Bedienvorrichtung eine Halteeinrichtung zum Halten des Bedienelements und zumindest ein Federelement auf, wobei das Bedienelement zu der Halteeinrichtung mittels des zumindest einen Federelements federnd gelagert ist. Somit ist das Bedienelement bewegbar an der Halteeinrichtung gelagert. Dies bedeutet, dass das Bedienelement beispielsweise bei der Bedieneingabe von einer Ausgangslage beziehungsweise Ruhelage ausgelenkt werden kann. Mit dem zumindest einen Federelement kann dann eine Rückstellkraft bereitgestellt werden, die der Kraft, die bei der Bedienung auf das Bedienelement ausgeübt wird, entgegengesetzt ist. Somit kann erreicht werden, dass das Bedienelement wieder in die Ausgangslage zurück gelangt. Das Federelement kann beispielsweise aus einem Federdraht gebildet sein und als Spiralfeder ausgebildet sein. Bevorzugt ist das zumindest eine Federelement aber aus einem dämpfenden Material, beispielsweise Silikon, gefertigt.

In einer weiteren Ausführungsform ist der Elektromagnet mit der Halteeinrichtung verbunden und das Bewegungselement ist durch die Ansteuerung des Elektromagneten relativ zu dem Elektromagneten bewegbar. Der Elektromagnet, der eine Spule umfassen kann, kann beispielsweise mittels einer entsprechenden Schraubverbindung an der Halteeinrichtung gehalten sein. Dabei ist das Bewegungselement relativ zu dem Elektromagneten bewegbar. Beispielsweise kann es vorgesehen sein, dass das Bewegungselement gegen das Bedienelement infolge der Ansteuerung des Elektromagneten gedrückt wird.

In einer Ausführungsform ist das Bewegungselement mit dem Bedienelement verbunden. Dabei kann es auch vorgesehen sein, dass an dem Bedienelement ein entsprechendes Befestigungselement angeordnet ist, mittels welchem das Bewegungselement an dem Bedienelement gehalten ist. Wie bereits erwähnt, ist der Elektromagnet bevorzugt an der Halteeinrichtung gehalten. Wenn das Bewegungselement mit dem Bedienelement verbunden ist, kann durch die Ansteuerung des Elektromagneten das Bewegungselement und somit auch das Bedienelement, das mit dem Bewegungselement verbunden ist, bewegt werden. Dabei kann die Antriebseinrichtung so ausgebildet sein, dass das Bewegungselement und somit auch das Bedienelement in Richtung des Elektromagneten gezogen werden. Durch eine entsprechende Ansteuerung des Elektromagneten kann dann eine periodische Bewegung des Bewegungselements bewirkt werden. Damit können das Bewegungselement und das Bedienelement, das mit dem Bewegungselement verbunden ist, in mechanischen Schwingungen beziehungsweise Vibrationen versetzt werden. Grundsätzlich kann das Bedienelement durch die Bewegung des Bewegungselements in mindestens eine mechanische Schwingung versetzt werden. Es kann auch vorgesehen sein, dass das Bedienelement in eine Schwingung versetzt wird, die sich aus mehreren Frequenzen zusammensetzt.

In einer weiteren Ausgestaltung ist das Bewegungselement relativ zu dem Bedienelement bewegbar und die Antriebseinrichtung ist derart ausgebildet, dass das Bewegungselement bei der Bewegung auf das Bedienelement auftrifft. Bei dieser Ausführungsform ist das Bewegungselement nicht mit dem Bedienelement verbunden. Das Bedienelement ist in diesem Fall relativ zu dem Elektromagneten und relativ zu dem Bedienelement bewegbar. Beispielsweise kann das Bewegungselement gelagert gehalten sein. Dabei ist das Bewegungselement insbesondere aus einem magnetischen Material gebildet und durch die Ansteuerung des Elektromagneten wird das Bewegungselement von dem Elektromagneten abgestoßen. Dabei sind der Elektromagnet, das Bewegungselement und das Bedienelement derart zueinander angeordnet, dass das Bewegungselement bei der Bewegung auf das Bedienelement auftrifft. Mit anderen Worten wird das Bewegungselement von dem Elektromagneten abgestoßen und schlägt auf das Bedienelement auf. Auch auf diese Weise kann zuverlässig eine haptische Rückmeldung an den Bediener ausgegeben werden.

In einer weiteren Ausführungsform weist das Bewegungselement ein Plattenelement, welches mit dem Elektromagneten bewegbar ist, und zumindest einen mit dem Plattenelement verbunden Stößel auf, welcher bei der Bewegung des Plattenelements auf das Bedienelement auftrifft. Der Elektromagnet kann stationär beziehungsweise nicht beweglich zu dem Bedienelement angeordnet sein. Das Plattenelement kann insbesondere aus einem Metall gebildet sein. Das Bedienelement kann dabei auf einer ersten Seite des Elektromagneten und das Plattenelement kann auf einer der ersten Seite gegenüberliegenden, zweiten Seite des Elektromagneten angeordnet sein. Die Stößel können beispielsweise senkrecht zu der Haupterstreckungsrichtung des Plattenelements und/oder senkrecht zur Haupterstreckungsrichtung des Bedienelements angeordnet sein. Wenn der Elektromagnet aktiviert wird, kann das Plattenelement in Richtung des Elektromagneten gezogen werden. Damit werden auch die Stößel beschleunigt und treffen auf das Bedienelement auf. Da das Bewegungselement eine verhältnismäßig geringe Masse aufweist, kann das Bewegungselement infolge der Ansteuerung des Elektromagneten entsprechend beschleunigt werden. Damit kann durch das Auftreffen der Stößel auf das Bedienelement eine haptische Rückmeldung ausgegeben werden, die einem Klopfen entspricht.

In einer weiteren Ausgestaltung ist das Bewegungselement federnd gelagert. Hierzu kann beispielsweise in Federelement in Form einer Spiralfeder in den jeweiligen Stößeln angeordnet sein. Mittels der jeweiligen Federelemente kann das Bewegungselement an einem Trägerelement beziehungsweise an einem Gehäuse der Bedienvorrichtung federnd gelagert sein. Damit kann garantiert werden, dass das Bewegungselement wieder in seine Ausgangslage zurückbewegt wird, falls der Elektromagnet deaktiviert wird.

Weiterhin ist es vorteilhaft, wenn das Bewegungselement einen Grundkörper umfasst, welcher zumindest bereichsweise mit einem magnetisierbaren Material oder einem magnetischen Material beschichtet ist. Bei dem Grundkörper kann es sich beispielsweise um ein elektrisch isolierendes Material, insbesondere einen Kunststoff, handeln. Dieser Grundkörper kann an seiner Außenfläche beziehungsweise an der dem Elektromagneten zugewandten Fläche mit dem magnetisierbaren Material oder mit dem magnetischen Material beschichtet sein. Wenn der Grundkörper beispielsweise aus einem Kunststoff gefertigt wird und das magnetisierbare Material oder das magnetische Material als Beschichtung aufgebracht wird, kann das Bewegungselement besonders kostengünstig gefertigt werden. Zudem kann ein Bewegungselement bereitgestellt werden, das ein geringes Gewicht aufweist. Hierbei haben Versuche gezeigt, dass das Gewicht des Bewegungselements sich negativ auf die Haptik auswirkt, da die Beschleunigung mit steigender Masse des Bewegungselements sinkt.

Es kann grundsätzlich auch vorgesehen sein, dass das Bewegungselement vollständig aus dem magnetisierbaren Material oder dem magnetischen Material gebildet ist. Beispielsweise kann das Bewegungselement als Platte ausgebildet sein. Hierbei kann die Platte so ausgebildet sein, dass diese eine verhältnismäßig geringe Dicke aufweist. Auf diese Weise kann das Bewegungselement ausreichend beschleunigt werden und somit die haptische Rückmeldung zuverlässig ausgegeben werden.

In einer weiteren Ausführungsform umfasst das Bedienelement eine Anzeigeeinrichtung. Eine solche Anzeigeeinrichtung kann beispielsweise ein Bildschirm oder ein Display sein. Es kann vorgesehen sein, dass die Bedienvorrichtung einen berührungsempfindlichen Bildschirm beziehungsweise einen Touchscreen umfasst. In diesem Fall ist die Erfassungseinrichtung beispielsweise durch den berührungsempfindlichen Sensor des berührungsempfindlichen Bildschirms gebildet. Mit Hilfe der Anzeigeeinrichtung können den Insassen des Kraftfahrzeugs zudem Informationen dargestellt werden.

Ein erfindungsgemäßes Kraftfahrzeug umfasst eine erfindungsgemäße Bedienvorrichtung. Das Kraftfahrzeug ist insbesondere als Personenkraftwagen ausgebildet.

Die mit Bezug auf die erfindungsgemäße Bedienvorrichtung vorgestellten bevorzugten Ausführungsformen und deren Vorteile gelten entsprechend für das erfindungsgemäße Kraftfahrzeug.

Weitere Merkmale der Erfindung ergeben sich aus den Ansprüchen, den Figuren und der Figurenbeschreibung. Die vorstehend in der Beschreibung genannten Merkmale und Merkmalskombinationen, sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale eines ursprünglich formulierten unabhängigen Anspruchs aufweisen.

Die Erfindung wird nun anhand von bevorzugten Ausführungsbeispielen sowie unter Bezugnahme auf die beigefügten Zeichnungen näher erläutert.

Dabei zeigen:
- Fig. 1: ein Kraftfahrzeug gemäß einer Ausführungsform der vorliegenden Erfindung, welches eine Bedienvorrichtung aufweist;
- Fig. 2: die Bedienvorrichtung gemäß einer ersten Ausführungsform in einer Explosionsdarstellung;
- Fig. 3: die Bedienvorrichtung gemäß Fig. 2 in einer geschnittenen Perspektivansicht;
- Fig. 4: die Bedienvorrichtung gemäß Fig. 2 in einer geschnittenen Seitenansicht; und
- Fig. 5: die Bedienvorrichtung gemäß einer zweiten Ausführungsform in einer geschnittenen Seitenansicht.

In den Figuren werden gleiche und funktionsgleiche Elemente mit den gleichen Bezugszeichen versehen.

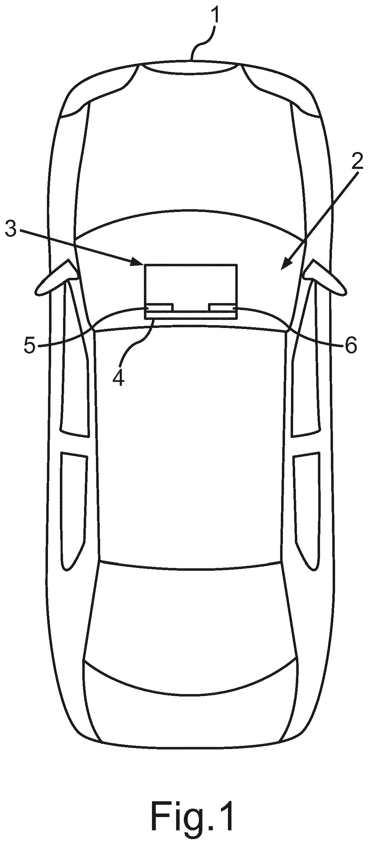

Fig. 1 zeigt ein Kraftfahrzeug 1 gemäß einer Ausführungsform der vorliegenden Erfindung in einer Draufsicht. Das Kraftfahrzeug 1 ist vorliegend als Personenkraftwagen ausgebildet. Das Kraftfahrzeug 1 umfasst einen Innenraum 2, in welchem eine Bedienvorrichtung 3 angeordnet ist. Die Bedienvorrichtung 3, welche vorliegend schematisch dargestellt ist, umfasst ein Bedienelement 4, welches von einem Insassen des Kraftfahrzeugs 1 bedient werden kann. Dabei kann die Bedienvorrichtung 3 derart in dem Innenraum 2 des Kraftfahrzeugs 1 angeordnet sein, dass das Bedienelement 4 dem Insassen des Kraftfahrzeugs 1 zugewandt ist.

Mit der Bedienvorrichtung 3 kann eine Bedienhandlung in Form der Betätigung des Bedienelements 4 erfasst werden. Zu diesem Zweck weist die Bedienvorrichtung 3 eine Erfassungseinrichtung 5 auf. Die Erfassungseinrichtung 5 kann beispielsweise einen berührungsempfindlichen Sensor umfassen. Mit dieser Erfassungseinrichtung 5 kann beispielsweise eine Berührung mit zumindest einem Finger oder einem entsprechenden Eingabegerät auf der Bedienfläche 4 erfasst werden. Darüber hinaus kann mit der Erfassungseinrichtung 5 die Position der Berührung auf dem Bedienelement 4 erkannt werden. Ferner umfasst die Bedienvorrichtung 3 eine Antriebseinrichtung 6. Mittels der Antriebseinrichtung 6 kann das Bedienelement 4 zum Ausgeben einer haptischen Rückmeldung an den Insassen beziehungsweise den Bediener bewegt werden. Falls mit der Erfassungseinrichtung 5 die Bedienhandlung beziehungsweise die Berührung des Bedienelements 4 erkannt wird, kann ein entsprechendes Steuersignal an die Antriebseinrichtung 6 ausgegeben werden. Infolge des Steuersignals kann dann die Antriebseinrichtung 6 das Bedienelement 4 bewegen.

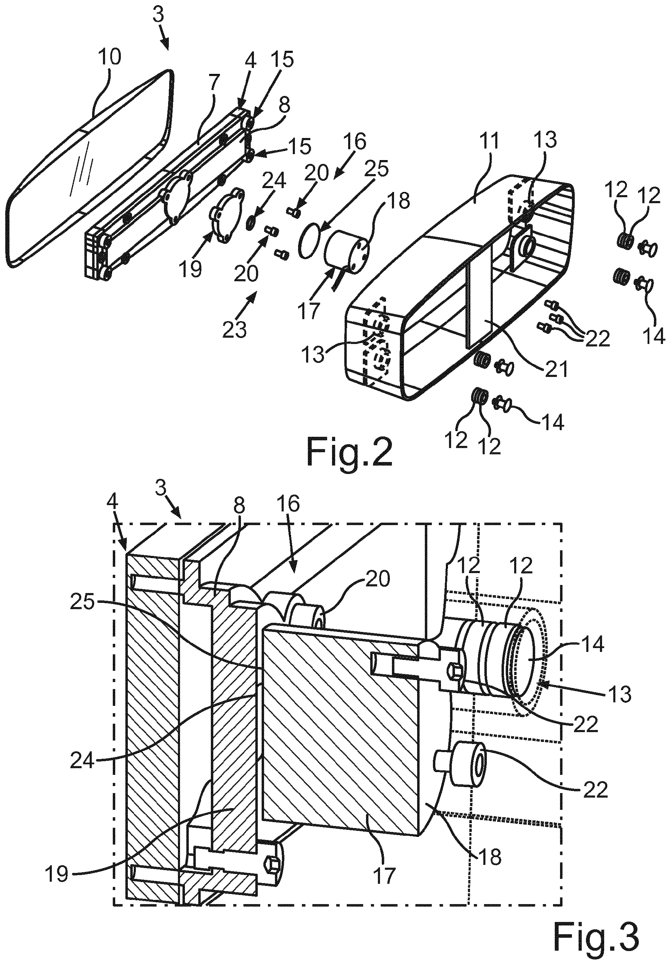

Fig. 2 zeigt die Bedienvorrichtung 3 gemäß einer ersten Ausführungsform in einer Explosionsdarstellung. Dabei umfasst das Bedienelement 4 eine Anzeigeeinrichtung 7. Die Anzeigeeinrichtung 7 kann als Bildschirm und insbesondere als TFT-Bildschirm ausgebildet sein. Ferner ist eine Halteplatte 8 zum Halten der Anzeigeeinrichtung 7 vorgesehen. Dabei ist die Anzeigeeinrichtung 7 mit der Halteplatte 8 verbunden. Darüber hinaus umfasst die Bedienvorrichtung 3 ein Abdeckelement 10, das beispielsweise aus Glas gebildet sein kann. Das Abdeckelement 10 kann auf der Anzeigeeinrichtung 7 angeordnet werden und dient zum Schutz der Anzeigeeinrichtung 7. Darüber hinaus umfasst die Bedienvorrichtung 3 eine Halteeinrichtung 11. Die Halteeinrichtung 11 dient zum Halten des Bedienelements 4. Dabei ist das Bedienelement 4 federnd an der Halteeinrichtung 11 gelagert. Hierzu weist die Bedienvorrichtung 3 Federelemente 12 auf, die vorliegend hohlzylinderförmig ausgebildet sind und aus einem elastischen Material, insbesondere Silikon, gefertigt sind. Diese Federelemente 12 können in korrespondierenden Aufnahmen 13 der Halteeinrichtung 11 eingebracht werden. Die Federelemente 12 sind mit entsprechenden Befestigungselementen 14, die vorliegend als Schrauben ausgebildet sind, in den korrespondierenden Aufnahmen 13 gehalten. Vorliegend werden die Befestigungselemente 14 beziehungsweise die Schrauben in Gewinde 15 an der Halteplatte 8 eingedreht.

Des Weiteren umfasst die Bedienvorrichtung 3 eine Antriebseinrichtung 16. Die Antriebseinrichtung 16 umfasst einen Elektromagneten 17, der eine entsprechende Spule umfassen kann, die in einem Gehäuse 18 angeordnet ist. Darüber hinaus umfasst die Antriebseinrichtung 16 ein Bewegungselement 19. Das Bewegungselement 19 kann grundsätzlich aus einem magnetisierbaren Material oder einem magnetischen Material gebildet sein. Vorliegend ist das Bewegungselement 19 im Wesentlichen plattenförmig ausgebildet und aus einem magnetisierbaren Material gefertigt. Beispielsweise ist das Bewegungselement 19 aus einem Metall gebildet. Das Bewegungselement 19 kann mit Hilfe von entsprechenden Befestigungselementen 20, die vorliegend als Schrauben ausgebildet sind, an der Halteplatte 8 des Bedienelements 4 befestigt werden. Der Elektromagnet 17 ist mit der Halteeinrichtung 11 verbunden. Hierzu weist die Halteeinrichtung 11 einen entsprechenden Steg 21 auf, an dem der Elektromagnet 17 mit entsprechenden Befestigungsmitteln 22, die als Schrauben ausgebildet sind, gehalten ist.

Im Betrieb der Antriebseinrichtung 16 wird der Elektromagnet 17 entsprechend angesteuert. So kann in die Spule des Elektromagneten 17 ein elektrischer Strom eingeprägt werden. Somit wird mit dem Elektromagneten 17 ein Magnetfeld bereitgestellt, durch welches das Bewegungselement 19 in Richtung des Elektromagneten 17 bewegt wird. Das Bewegungselement 19 wird also von dem Elektromagneten 17 angezogen. Da der Elektromagnet 17 mit der Halteeinrichtung 11 verbunden ist und das Bewegungselement 19 mit dem Bedienelement 4 verbunden ist, kann durch die Ansteuerung des Elektromagneten 17 das Bedienelement 4 relativ zu der Halteeinrichtung 11 bewegt werden. Durch eine entsprechende Ansteuerung, beispielsweise eine periodische Ansteuerung, des Elektromagneten 17 kann das Bedienelement 4 in mechanische Schwingungen versetzt werden, um eine haptische Rückmeldung an den Bediener beziehungsweise den Insassen des Kraftfahrzeugs 1 auszugeben.

In einem Zwischenraum 23 zwischen dem Elektromagneten 17 und dem Bewegungselement 19 ist ein elastisches Element 24 angeordnet. Das elastische Element 24 ist nach Art eines Knackfrosches ausgebildet und kann zwischen einem stabilen Zustand und einem metastabilen Zustand verformt werden. Das elastische Element 24 kann beispielsweise aus einem entsprechenden Metallblech gebildet sein und eine derartige Formgebung aufweisen, dass es zwischen dem stabilen Zustand und dem metastabilen Zustand verformt werden kann. Wenn das Bewegungselement 19 infolge des mit dem Elektromagneten 17 bereitgestellten Magnetfelds auf den Elektromagneten 17 zu bewegt wird, wird das elastische Element 24 verformt. Hierbei nimmt das elastische Element 24 den metastabilen Zustand ein. Wenn die Spule des Elektromagneten 17 nicht bestromt wird, also mit dem Elektromagneten 17 kein Magnetfeld bereitgestellt wird, bewegt sich das Bewegungselement 19 wieder von dem Elektromagneten 17 weg und das elastische Element 24 gelangt wieder in den stabilen Zustand zurück. Durch diese Verformung des elastischen Elements 24 kann die haptische Rückmeldung, die an dem Bedienelement 4 ausgegeben wird, entsprechend gesteuert werden. Darüber hinaus ist zwischen dem Elektromagneten 17 und dem Bewegungselement 19 ein Dämpfungselement 25 angeordnet. Das Dämpfungselement 25 kann beispielsweise eine Gummimatte sein. Durch das Dämpfungselement 25 wird die Bewegung des Bewegungselements 19 in Richtung des Elektromagneten 17 gedämpft. Somit kann beispielsweise verhindert werden, dass das Bewegungselement 19 gegen den Elektromagneten 17 schlägt.

Fig. 3 zeigt die Bedienvorrichtung 3 gemäß Fig. 2 in einer geschnittenen Perspektivansicht. Hierbei ist die Bedienvorrichtung 3 im montierten Zustand gezeigt. Hierbei ist zu erkennen, dass zwischen dem Bewegungselement 19 und dem Elektromagneten 17 der Zwischenraum 23 beziehungsweise ein Luftspalt ausgebildet ist. Dabei sind der Elektromagnet 17 und das Bewegungselement 19 derart zueinander angeordnet, dass auch während der Bewegung des Bewegungselements19 relativ zu dem Elektromagneten 17 immer einen Mindestabstand zwischen dem Elektromagneten 17 und dem Bewegungselement 19 bestehen bleibt. Somit kann das Bewegungselement 19 mittels des Elektromagneten 17 bewegt werden, ohne dass ein direkter Kontakt zwischen dem Bewegungselement 19 und dem Elektromagneten 17 vorliegt und somit beispielsweise ein magnetischer Kreis geschlossen wird. Dadurch, dass der Mindestabstand beziehungsweise der Zwischenraum oder der Luftspalt zwischen dem Elektromagneten 17 und dem Bewegungselement 19 eingehalten wird, können das elastische Element 24 und das Dämpfungselement 25 zwischen dem Elektromagneten 17 und dem Bewegungselement 19 angeordnet werden.

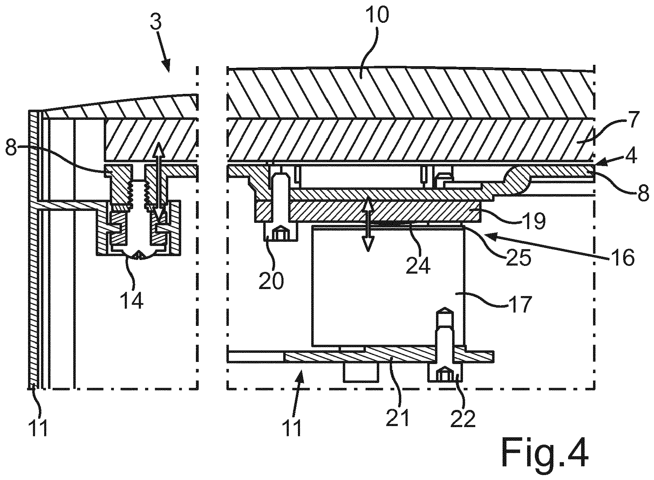

Fig. 4 zeigt die Bedienvorrichtung 3 gemäß Fig. 2 in einer geschnittenen Seitenansicht. Hierbei sind die Federelement 12 zu erkennen, die in den jeweiligen korrespondierenden Aufnehmungen 13 angeordnet sind. Zudem ist die Halteplatte 8, an welcher die Anzeigeeinrichtung 7 angeordnet ist, zu erkennen, die federnd an der Halteeinrichtung 11 gelagert ist. Darüber hinaus ist die Befestigung des Bewegungselements 19 an der Halteplatte 8 gezeigt. Ferner ist zu erkennen, dass der Elektromagnet 17 an der Halteeinrichtung 11 beziehungsweise an dem Steg 21 befestigt ist.

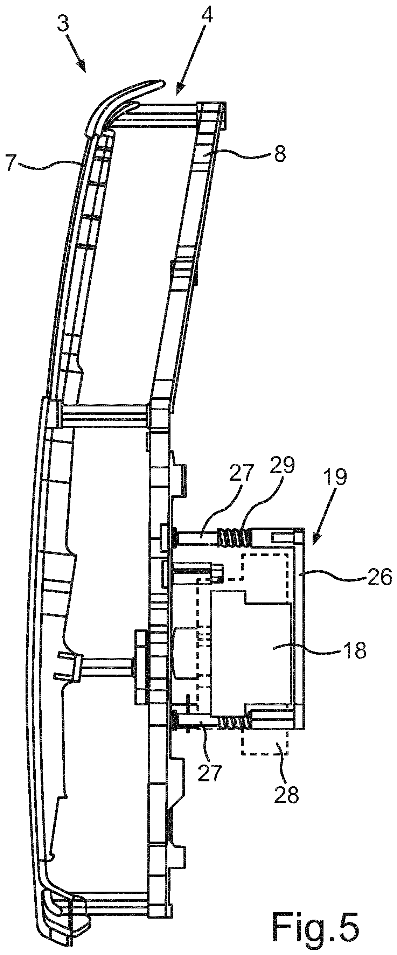

Fig. 5 zeigt die Bedienvorrichtung 3 gemäß einer zweiten Ausführungsform in einer geschnittenen Seitenansicht. Der Elektromagnet 18 ist dabei mittels eines Trägerelements 28 gehalten. Dieses Trägerelement 28 kann beispielsweise an einem Gehäuse der Bedienvorrichtung 3 befestigt sein. Ferner ist der Elektromagnet 18 mit der Halteplatte 8 verbunden. Hier weist das Bewegungselement 19 ein Plattenelement 26 und eine Mehrzahl von Stößel 27, die mit dem Plattenelement 26 verbunden sind, auf. Dabei ist das Plattenelement 26 so angeordnet, dass sich das Plattenelement 26 auf einer ersten Seite des Elektromagneten 18 und das Bedienelement 4 auf einer der ersten Seite gegenüberliegenden, zweiten Seite des Elektromagneten 18 befindet. Das Bewegungselement 19 kann beispielsweise drei Stößel 27 aufweisen, von denen in der vorliegenden Ansicht zwei zu erkennen sind. Das Plattenelement 26 kann beispielsweise aus einem Metall gebildet sein.

Wenn der Elektromagnet 18 aktiviert wird, wird das Plattenelement 26 in Richtung des Elektromagneten 18 bewegt. Dadurch werden die Stößel 27 in Richtung des Bedienelements 4 beschleunigt und treffen auf das Bedienelement 4 beziehungsweise auf die Halteplatte 8 auf. Da das Bewegungselement 19 in dieser Ausführungsform eine geringe Masse aufweist, kann es mittels des Elektromagneten 18 effektiv beschleunigt werden. Damit kann eine haptische Rückmeldung bereitgestellt werden, die einem Klopfen entspricht. Ferner sind Federelemente 29 vorgesehen, mittels welcher das Bewegungselement 19 federnd an dem Trägerelement 28 gelagert ist. Mittels der Federelemente 29 kann ermöglicht werden, dass das Bewegungselement 19 wieder in die Ausgangslage beziehungsweise Ruhestellung zurückbewegt wird.

## Patentansprüche

1. Bedienvorrichtung (3) für ein Kraftfahrzeug (1), mit einem Bedienelement (4), mit einer Erfassungseinrichtung (5) zum Erfassen einer an dem Bedienelement (4) durchgeführten Bedieneingabe und einer Antriebseinrichtung (6), mittels welcher das Bedienelement (4) in Abhängigkeit von der mit der Erfassungseinrichtung (5) erfassten Bedieneingabe zum Ausgeben einer haptischen Rückmeldung bewegbar ist, wobei die Antriebseinrichtung (6) einen Elektromagneten (17) und ein Bewegungselement (19), welches durch eine Ansteuerung des Elektromagneten (17) bewegbar ist, aufweist,
wobei der Elektromagnet (17) und das Bewegungselement (19) derart zueinander angeordnet sind, dass beim Bewegen des Bewegungselements (19) ein vorbestimmter Abstand zwischen dem Elektromagneten (17) und dem Bewegungselement (19) bestehen bleibt,
**dadurch gekennzeichnet, dass**,
die Antriebseinrichtung (6) ein elastisches Element (24) umfasst, welches durch die Bewegung des Bewegungselements (19) von einem stabilen Zustand in einen metastabilen Zustand verformbar ist.

2. Bedienvorrichtung (3) nach Anspruch 1,
**dadurch gekennzeichnet, dass**
zwischen dem Elektromagneten (17) und dem Bewegungselement (19) zumindest ein Dämpfungselement (25) angeordnet ist.

3. Bedienvorrichtung (3) nach einem der vorhergehenden Ansprüche,
**dadurch gekennzeichnet, dass**
die Bedienvorrichtung (3) eine Halteeinrichtung (11) zum Halten des Bedienelements (4) und zumindest ein Federelement (12) aufweist, wobei das Bedienelement (4) zu der Halteeinrichtung (11) mittels des zumindest einen Federelements (12) federnd gelagert ist.

4. Bedienvorrichtung (3) nach Anspruch 3,
**dadurch gekennzeichnet, dass**
der Elektromagnet (17) mit der Halteeinrichtung (11) verbunden ist und das Bewegungselement (19) durch die Ansteuerung des Elektromagneten (17) relativ zu dem Elektromagneten (17) bewegbar ist.

5. Bedienvorrichtung (3) nach einem der vorhergehenden Ansprüche,
**dadurch gekennzeichnet, dass**
das Bewegungselement (19) mit dem Bedienelement (4) verbunden ist.

6. Bedienvorrichtung (3) nach einem der Ansprüche 1 bis 4,
**dadurch gekennzeichnet, dass**
das Bewegungselement (19) relativ zu dem Bedienelement (4) bewegbar ist und die Antriebseinrichtung (6) derart ausgebildet ist, dass das Bewegungselement (19) bei der Bewegung auf das Bedienelement (4) auftrifft.

7. Bedienvorrichtung (3) nach Anspruch 6,
**dadurch gekennzeichnet, dass**
das Bewegungselement (19) ein Plattenelement (26), welches mit dem Elektromagneten (18) bewegbar ist, und zumindest einen mit dem Plattenelement (26) verbunden Stößel (27) aufweist, welcher bei der Bewegung des Plattenelements (26) auf das Bedienelement (4) auftrifft.

8. Bedienvorrichtung nach Anspruch 6 oder 7,
**dadurch gekennzeichnet, dass**
das Bewegungselement (19) federnd gelagert ist.

9. Bedienvorrichtung (3) nach einem der vorhergehenden Ansprüche,
**dadurch gekennzeichnet, dass**
das Bewegungselement (19) einen Grundkörper umfasst, welcher zumindest bereichsweise mit einem magnetisierbaren Material oder einem magnetischen Material beschichtet ist.

10. Bedienvorrichtung (3) nach einem der vorhergehenden Ansprüche,
**dadurch gekennzeichnet, dass**
das Bedienelement (4) eine Anzeigeeinrichtung (7) umfasst.

11. Kraftfahrzeug (1) mit einer Bedienvorrichtung (3) nach einem der vorhergehenden Ansprüche.

## Claims

1. Operator control apparatus (3) for a motor vehicle (1), comprising an operator control element (4), comprising a detection device (5) for detecting an operator control input which is carried out on the operator control element (4), and comprising a drive device (6) by means of which the operator control element (4) can be moved, depending on the operator control input which is detected by the detection device (5), for outputting haptic feedback, wherein the drive device (6) has an electromagnet (17) and a movement element (19) which can be moved by actuating the electromagnet (17), wherein the electromagnet (17) and the movement element (19) are arranged in relation to one another in such a way that, during movement of the movement element (19), a predetermined distance remains between the electromagnet (17) and the movement element (19), **characterized in that** the drive device (6) comprises an elastic element (24) which can be deformed from a stable state to a metastable state by the movement of the movement element (19).

2. Operator control apparatus (3) according to Claim 1, **characterized in that** at least one damping element (25) is arranged between the electromagnet (17) and the movement element (19).

3. Operator control apparatus (3) according to either of the preceding claims, **characterized in that** the operator control apparatus (3) has a holding device (11) for holding the operator control element (4) and at least one spring element (12), wherein the operator control element (4) is mounted in a resilient manner in relation to the holding device (11) by means of the at least one spring element (12).

4. Operator control apparatus (3) according to Claim 3, **characterized in that** the electromagnet (17) is connected to the holding device (11) and the movement element (19) can be moved relative to the electromagnet (17) by actuating the electromagnet (17).

5. Operator control apparatus (3) according to one of the preceding claims, **characterized in that** the movement element (19) is connected to the operator control element (4) .

6. Operator control apparatus (3) according to one of Claims 1 to 4, **characterized in that** the movement element (19) can be moved relative to the operator control element (4) and the drive device (6) is designed in such a way that the movement element (19) strikes the operator control element (4) during the movement.

7. Operator control apparatus (3) according to Claim 6, **characterized in that** the movement element (19) has a plate element (26), which can be moved with the electromagnet (18), and at least one tappet (27) which is connected to the plate element (26) and strikes the operator control element (4) during the movement of the plate element (26).

8. Operator control apparatus according to Claim 6 or 7, **characterized in that** the movement element (19) is mounted in a resilient manner.

9. Operator control apparatus (3) according to one of the preceding claims, **characterized in that** the movement element (19) comprises a main body which is coated with a magnetizable material or a magnetic material at least in regions.

10. Operator control apparatus (3) according to one of the preceding claims, **characterized in that** the operator control element (4) comprises a display device (7).

11. Motor vehicle (1) comprising an operator control apparatus (3) according to one of the preceding claims.

## Revendications

1. Dispositif de commande (3) destiné à un véhicule automobile (1), ledit dispositif de commande comprenant un élément de commande (4), un moyen de détection (5) destiné à détecter une entrée de commande effectuée au niveau de l'élément de commande (4) et un moyen d'entraînement (6) permettant de déplacer l'élément de commande (4) en fonction de l'entrée de commande détectée à l'aide du moyen de détection (5) pour délivrer un retour haptique, le moyen d'entraînement (6) comportant un électroaimant (17) et un élément de déplacement (19) qui peut être déplacé par excitation de l'électroaimant (17),
l'électroaimant (17) et l'élément de déplacement (19) étant disposés l'un par rapport à l'autre de manière à ménager une distance prédéterminée entre l'électroaimant (17) et l'élément de déplacement (19) lorsque l'élément de déplacement (19) est déplacé, **caractérisé en ce que**,
le moyen d'entraînement (6) comprend un élément élastique (24) qui peut être déformé d'un état stable à un état métastable par déplacement de l'élément de déplacement (19).

2. Dispositif de commande (3) selon la revendication 1,
**caractérisé en ce que**
au moins un élément d'amortissement (25) est disposé entre l'électroaimant (17) et l'élément de déplacement (19) .

3. Dispositif de commande (3) selon l'une des revendications précédentes,
**caractérisé en ce que**
le dispositif de commande (3) comporte un moyen de retenue (11) destiné à retenir l'élément de commande (4) et au moins un élément à ressort (12), l'élément de commande (4) étant monté à ressort par rapport au moyen de retenue (11) à l'aide de l'au moins un élément à ressort (12).

4. Dispositif de commande (3) selon la revendication 3,
**caractérisé en ce que**
l'électroaimant (17) est relié au moyen de retenue (11) et l'élément de déplacement (19) peut être déplacé par rapport à l'électroaimant (17) par excitation de l'électroaimant (17).

5. Dispositif de commande (3) selon l'une des revendications précédentes,
**caractérisé en ce que**
l'élément de déplacement (19) est relié à l'élément de commande (4).

6. Dispositif de commande (3) selon l'une des revendications 1 à 4,
**caractérisé en ce que**
l'élément de déplacement (19) est mobile par rapport à l'élément de commande (4) et le moyen d'entraînement (6) est conçu de telle sorte que l'élément de déplacement (19) vient heurter l'élément de commande (4) pendant le déplacement.

7. Dispositif de commande (3) selon la revendication 6,
**caractérisé en ce que**
l'élément de déplacement (19) comporte un élément formant plaque (26), qui peut être déplacé à l'aide de l'électroaimant (18), et au moins un piston (27) qui est relié à l'élément formant plaque (26) et qui vient heurter l'élément de commande (4) lorsque l'élément formant plaque (26) se déplace.

8. Dispositif de commande selon la revendication 6 ou 7,
**caractérisé en ce que**
l'élément de déplacement (19) est monté sur ressort.

9. Dispositif de commande (3) selon l'une des revendications précédentes,
**caractérisé en ce que**
l'élément de déplacement (19) comprend un corps de base qui est revêtu au moins par endroits d'un matériau magnétisable ou d'un matériau magnétique.

10. Dispositif de commande (3) selon l'une des revendications précédentes,
**caractérisé en ce que**
l'élément de commande (4) comprend un moyen d'affichage (7) .

11. Véhicule automobile (1) comprenant un dispositif de commande (3) selon l'une des revendications précédentes.
